# EUROPÄISCHE PATENTSCHRIFT

(11) **EP 4 441 784 B1**
(45) Veröffentlichungstag und Bekanntmachung des Hinweises auf die Patenterteilung: **31.12.2025**
(21) Anmeldenummer: 22817236.7
(22) Anmeldetag: 11.11.2022
(51) Int. Cl.: H01L 23/373, H01L 23/473, H01L 21/48, F28F 19/02, H01S 5/024

(54) **TRÄGERELEMENT FÜR ELEKTRISCHE BAUTEILE UND VERFAHREN ZUR HERSTELLUNG EINES SOLCHEN TRÄGERELEMENTS**
CARRIER ELEMENT FOR ELECTRICAL COMPONENTS, AND METHOD FOR PRODUCING A CARRIER ELEMENT OF THIS TYPE
ÉLÉMENT PORTEUR POUR COMPOSANTS ÉLECTRIQUES ET PROCÉDÉ DE FABRICATION D'UN ÉLÉMENT PORTEUR DE CE TYPE

(30) Priorität: 03.12.2021 DE 102021131902
(43) Veröffentlichungstag der Anmeldung: 09.10.2024
(73) Patentinhaber: Rogers Germany GmbH, 92676 Eschenbach (DE)
(72) Erfinder: SCHMIDT, Karsten, 92676 Eschenbach (DE); WIESEND, Johannes, 93676 Speinshart (DE)
(74) Vertreter: Müller Schupfner & Partner Patent- und Rechtsanwaltspartnerschaft mbB (Muc)
(86) Internationale Anmeldenummer: PCT/EP2022/081652
(87) Internationale Veröffentlichungsnummer: WO 2023/099171

(56) Entgegenhaltungen:
- WO-A2-2009/052817
- CN-A- 102 208 377
- DE-A1- 102018 112 000
- DE-A1- 102020 104 493

## Beschreibung

Die vorliegende Erfindung betrifft ein Trägerelement für elektrische Bauteile und ein Verfahren zur Herstellung eines solchen Trägerelements.

Aus dem Stand der Technik sind Kühlkörper zum Kühlen von elektrischen bzw. elektronischen Bauteilen, insbesondere Halbleitern, wie z. B. Laserdioden, hinlänglich bekannt. Dabei entwickeln die elektrischen bzw. elektronischen Bauteile während ihres Betriebs Wärme, die mittels des Kühlkörpers abgeführt wird, um so wiederum eine dauerhafte Funktionalität der elektrischen bzw. elektronischen Bauteile zu gewährleisten. Dies trifft insbesondere für Laserdioden zu, bei denen bereits Temperaturunterschiede von wenigen °C zu signifikanten Beeinträchtigungen der Leistung und/oder Lebensdauer führen können.

Zum Kühlen der Bauteile weisen die Kühlkörper, die in der Regel an die Bauteile angebunden sind, typischerweise ein Kühlfluidkanalsystem auf, durch das im Betrieb ein Kühlfluid geleitet wird, um vom elektrischen bzw. elektronischen Bauteil ausgehende Wärme aufzunehmen und abzutransportieren. Vorzugsweise wird hierbei eine Finnenstruktur verwendet, bei der mehrere stegartige Elemente in das Kühlfluidkanalsystem hineinragen, um eine möglichst große Kontaktfläche zum Kühlfluid bereitzustellen, wodurch die Wärmeübertragung von Wandungen, die das Kühlfluidkanalsystem begrenzen, auf das Kühlfluid verbessert wird.

Außerdem ist es üblich Kühlkörper zum Kühlen von Leiterplatten zu verwenden, die als Metall-Keramik-Substrate ausgebildet sind.

Für eine hohe thermische Leitfähigkeit werden üblicherweise Metalle zur Bildung der Kühlstruktur verwendet. Diese sind allerdings anfällig für Korrosion, wenn sie dauerhaft eine Kühlflüssigkeit ausgesetzt werden. Zum Schutz vor Korrosion ist es dabei üblich eine Nickelbeschichtung vorzusehen.

Aus der CN 102 208 377 A ist es ferner bekannt, einen Kühlkörper mit Finnen mit einer SiO₂- Schicht zu beschichten. Allerdings betrifft die Lehre einen einstückig ausgebildeten Kühlkörper.

Die DE 10 2020 104 493 A1 beschreibt das Herstellen eines Kühlkörpers aus mehreren Lagen mit Ausnehmungen. Die DE 10 2018 112 000 A1 betrifft eine Verteilstruktur, mit der ein Kühlfluid in einzelne Kühlkanäle in einem Kühlkörper eingeleitet wird. Die WO 2009 052817 A2 beschreibt ein Korrosionsschutz für Mikrokanalwärmesenken.

Die vorliegende Erfindung macht es sich zur Aufgabe, die Lebensdauer und Herstellung eines Korrosionsschutzes für bestimmte Kühlkörper zu verbessern.

Diese Aufgabe wird durch das Trägerelement gemäß Anspruch 1 und durch das Verfahren gemäß Anspruch 9 gelöst. Weitere Vorteile und Merkmale der Erfindung ergeben sich aus den Unteransprüchen sowie der Beschreibung und den beigefügten Figuren.

Gemäß einem ersten Aspekt der vorliegenden Erfindung ist ein Trägerelement für elektrische Bauteile vorgesehen, wobei das Trägerelement zum Abführen von Wärme, die vom elektrischen Bauteil während dessen Betrieb ausgeht, einen metallischen Kühlkörper umfasst, wobei der Kühlkörper eine Metallkörnung mit einer durchschnittlichen Korngröße aufweist, wobei die durchschnittliche Korngröße in einem Bereich zwischen 10 µm und 800 µm, bevorzugt zwischen 100 µm und 700 µm und besonders bevorzugt zwischen 300 und 600 µm liegt, wobei der Kühlkörper zumindest abschnittsweise eine oxidhaltige Korrosionsschutzschicht umfasst. Hierzu wird das Linienschnittverfahren verwendet, dass beispielsweise in ASTM 112-13 beschrieben ist.

Die vorliegende Erfindung macht sich zu Nutze, dass der Kühlkörper Metallkörnungen vorsieht, die eine durchschnittliche Korngröße aufweisen, die zwischen 10 µm und 800 µm, bevorzugt zwischen 100 µm und 700 µm und besonders bevorzugt zwischen 300 µm und 600 µm liegt. Dadurch wird automatisch eine Oberflächenrauheit bereitgestellt, die sich vorteilhaft auf das Haftvermögen der Korrosionsschutzschicht an der Kühlstruktur bzw. dem Kühlkörper auswirkt. Dabei ist die Beschichtung mit der Korrosionsschutzschicht am Kühlkörper an dessen Außenseite, die im Kontakt steht mit der Kühlflüssigkeit, vorgesehen. Dadurch wird verhindert, dass der Kühlköper und/oder das Kühlsystem bzw. Komponenten im Kühlsystem mit der Zeit korrodiert, wodurch die Lebensdauer des Kühlkörpers und/oder des Kühlsystems bzw. Komponenten im Kühlsystem signifikant erhöht wird. Weiterhin erweist sich die Körnung mit der entsprechenden Korngröße, insbesondere im Bereich zwischen 300 µm und 600 µm, insofern als vorteilhaft, als dass der thermische Widerstand im Grenzbereich zwischen der Kühlflüssigkeit und der mit der Korrosionsschutzschicht versehenen Außenseite des Kühlkörpers verbessert, d. h. insbesondere reduziert, wird, um auf diese Weise eine Erhöhung des thermischen Widerstandes zu kompensieren, von der wiederum bei der Verwendung von einer Korrosionsschutzschicht ausgegangen werden muss. Infolgedessen ist es in vorteilhafter Weise möglich, die Korrosionsschutzschicht vorzusehen, ohne den Abtransport der Wärme von der Kühlstruktur zur Kühlflüssigkeit signifikant zu verschlechtern.

Vorzugsweise ist es dabei vorgesehen, dass die entsprechende Korngrößenverteilung bzw. Körnung im Kühlkörper durch den Herstellungsprozess bzw. einen Anbindungsprozess des Kühlkörpers ermöglicht wird. Dabei ist es insbesondere vorgesehen, dass die Kühlstruktur einer Temperatur ausgesetzt wurde, die höher ist als 600 °C, bevorzugt höher als 800 °C und besonders bevorzugt größer als 1000 °C. Dadurch setzt eine entsprechende Kornbildung bzw. Kristallisation ein, die dazu führt, dass sich die anspruchsgemäße Körnung einstellen, die sich als besonders vorteilhaft erwiesen haben im Zusammenhang mit der aufgetragenen Korrosionsschutzschicht. Eine anspruchsgemäße Korngrößenbildung ist daher nicht automatisch für jeden metallischen Kühlkörper anzunehmen.

Die Korngrößen werden über ein Linienschnittverfahren bestimmt. Linienschnittverfahren sind dem Fachmann bekannt und werden beispielsweise in ASTM 112-13 beschrieben. Vorzugsweise erfolgt eine mikroskopische Aufnahme von der Oberfläche der Oberfläche des Kühlkörpers. Die Vergrößerung wird so gewählt, dass durch das Linienraster mindestens 100 Körner geschnitten werden.

Beispielsweise werden hierbei jeweils zwei parallele Linien in x-Richtung und zwei parallele Linien in y-Richtung in die Aufnahme gelegt. Die Linien unterteilen die Aufnahme jeweils in drei gleichmäßig breite Streifen. Wenn ein Korn von einer dieser Linien über eine Länge hinweg geschnitten wird, so wird diese Länge L als Korngröße genommen. Für jedes von einer dieser Linien geschnittene Korn erhält man so eine Korngröße. Am Kreuzungspunkt zweier Linien erhält man für ein Korn zwei Werte, die beide in die Bestimmung der Korngrößenverteilung eingehen

Vorzugsweise ist vorgesehen, dass der Kühlkörper mindestens aus einer ersten Metallschicht und einer zweiten Metallschicht zusammengesetzt ist. Dabei ist es vorzugsweise vorgesehen, dass die erste Metallschicht und die zweite Metallschicht Ausnehmungen aufweisen, die im zusammengesetzten, insbesondere gestapelten, Zustand der ersten und zweiten Metallschicht zumindest bereichsweise überlappend bzw. entlang einer Stapelrichtung übereinander angeordnet sind. Dadurch wird durch die jeweils zumindest bereichsweise deckungsgleich angeordneten Ausnehmungen ein Teil eines Mikrokanals ausgebildet. Dabei ist es vorstellbar, dass die erste und zweite Metallschicht zueinander versetzt sind, wodurch im Bereich des im gefertigten Zustand ausgebildeten Kanals eine gestufte Kanalinnenseite ausgebildet ist. Grundsätzlich besteht ein Kühlkörper aus einer Vielzahl erster und zweiter Metallschichten, die übereinandergestapelt sind. Diese übereinander gestapelten ersten und zweiten Metallschichten lassen sich dann beispielsweise mittels eines Direktanbindungsverfahrens, eines Diffusionsanbindungsverfahrens oder durch ein Lötverfahren miteinander verbinden, sodass ein vorzugsweise einstückiger Körper entsteht.

Dieser Kühlkörper weist dann aufgrund der verwendeten Temperaturen während des Anbindungsverfahrens eine entsprechende bzw. anspruchsgemäße Körnung auf, sofern die geeigneten Ausgangsmaterialien für die erste und zweite Metallschicht und/oder eine geeignetes Temperaturprofil beim Anbinden verwendet wurden. Dabei würde der Fachmann auf eine entsprechende Reinheit der ersten und/oder zweiten Metallschicht achten, um die gewünschten Korngrößen zu realisieren. Vorzugsweise wird durch die übereinandergestapelten und miteinander verbundenen ersten und zweiten Metallschichten ein Mikrokanalsystem bereitgestellt, dass vorzugsweise vorgesehen ist, eine elektrische Komponente, insbesondere eine Laserdiode und oder Leistungstransistor, die direkt an den Kühlkörper oder über ein Adapterelement an den Kühlkörper angebunden ist, zu kühlen.

Vorzugsweise ist es vorgesehen, dass das Trägerelement ein Metall-Keramik-Substrat umfasst. Dabei ist es vorstellbar, dass der Kühlkörper unmittelbar an ein Keramikelement des Metall-Keramik-Substrats und/oder an eine Rückseitenmetallisierung, die einer Bauteilmetallisierung gegenüberliegt, angebunden ist. Bauteilmetallisierung und Rückseitenmetallisierung sind dabei vorzugsweise an gegenüberliegenden Seiten des Keramikelements zur Ausbildung des Metall-Keramik-Substrats angebunden. Solche Metall-Keramik-Substrate erweisen sich insbesondere als empfindlich bzgl. der Wärmeentwicklung der elektrischen Bauteile an der Bauteilseite, da aufgrund der unterschiedlichen thermischen Ausdehnungskoeffizienten leicht thermomechanische Spannungen generiert werden können, die zu einem Verbiegen des gesamten Trägerelements oder zu einem Auftrennen der Bindung zwischen Keramikelement und Metallschicht führen können. Daher ist es gerade für solche Metall-Keramik-Substrate von entscheidender Bedeutung, dass der thermische Widerstand des Gesamtsystems, insbesondere hinsichtlich des Übergangs von Kühlkörper zu Kühlflüssigkeit, nicht erhöht wird. Daher ist es besonders vorteilhaft hier eine entsprechende Korrosionsschutzschicht vorzusehen.

Besonders bevorzugt ist es vorgesehen, dass die Korrosionsschutzschicht SiO₂, TiO₂, Al₂O₃, ZrO, CaO, K₂O und/oder ZnO umfasst. Dabei hat sich insbesondere eine Korrosionsschutzschicht aus Siliziumdioxid, d. h. SiO₂ als vorteilhaft herausgestellt und es ist dadurch möglich, einen bis zu 1000-mal größeren Schutz vor Korrosion zu gewährleisten, was sich signifikant auf die Lebensdauer des hergestellten Kühlkörpers auswirkt. Vorzugsweise handelt es sich um einen nanoteilchenfreie Korrosionsschutzschicht. Weiterhin ist es von Vorteil, dass durch die siliziumdioxidhaltige Korrosionsschutzschicht die zulässige Strömungsgeschwindigkeit in der Kühlstruktur, d. h. in den Kühlkanälen, erhöht werden kann, wodurch die Kühlperformance verbessert wird. Weiterhin wird eine elektrische Isolation des Kühlkanals unterstützt.

Vorzugsweise ist es vorgesehen, dass die Korrosionsschutzschicht eine Dicke von weniger als 3 µm, bevorzugt weniger als 1000 nm und besonders bevorzugt weniger als 500 nm aufweist. Vorzugsweise ist die Dicke der Korrosionsschutzschicht größer als 20 nm, bevorzugt größer als 80 nm und besonders bevorzugt größer als 250 nm. Insbesondere ist es bevorzugt vorgesehen, dass die Dicke einen Wert zwischen 20 nm und 1000 nm, bevorzugt zwischen 100 nm und 750 nm und besonders bevorzugt zwischen 250 nm und 500 nm, annimmt. Derart dünne Korrosionsschutzschichten erweisen sich als besonders vorteilhaft, weil sie beispielsweise nicht dazu beitragen, dass der gebildete Mikrokanal oder die entsprechende Strukturierung im Kühlkörper durch die Korrosionsschutzschicht verstopft wird. Außerdem hängt der erzeugte thermische Widerstand von der Dicke der aufgetragenen Korrosionsschutzschicht ab, sodass mit entsprechend dünnen Korrosionsschutzschichten verhindert werden kann, dass ein zu hoher thermischer Widerstand zwischen Kühlkörper und Kühlflüssigkeit ausgebildet wird. Dabei erweist es sich für solche Schutzschichten, die mit Dicken in dem Bereich zwischen 1 µm und 3 µm ausgebildet sind, als vorteilhaft, dass sie mittels eines Sol-Gel-Verfahrens vergleichsweise einfach hergestellt werden können. Die Korrosionsschutzschichtdicke unterhalb von 500 nm lässt sich bevorzugt durch ein gasphysikalisches Abscheiden, beispielsweise durch Sputtern, realisieren. Dabei erweist es sich insbesondere als vorteilhaft, dass dadurch eine homogene Verteilung der Korrosionsschutzschichtdicke möglich ist, d. h. die Korrosionsschutzschichtdicke möglichst konstant ist. Mit anderen Worten: die Dicke der Korrosionsschutzschicht ist über ihre gesamte Erstreckung konstant, d. h. es liegen keine Abweichungen vom Mittelwert der Dicke der Korrosionsschutzschichtdicke vor, die größer sind als 15 %, bevorzugt größer als 10 % und besonders bevorzugt größer als 5 % des bestimmten Mittelwertes.

Vorzugsweise ist das Metall-Keramik-Substrat als Leiterplatte ausgebildet, bei der im gefertigten Zustand die mindestens eine Metallschicht, die an das Keramikelement angebunden ist, strukturiert ist. Beispielsweise ist es hierzu vorgesehen, dass nach dem Anbindungsschritt auch eine Strukturierung, beispielsweise durch Lasern, Ätzen und/oder eine mechanische Bearbeitung, vorgenommen wird, mit der Leiterbahnen und/oder Anschlüsse für elektrische oder elektronische Bauteile realisiert werden. Vorzugsweise ist es vorgesehen, dass an einem gefertigten Metall-Keramik-Substrat an dem Keramikelement, an dem der Metallschicht gegenüberliegenden Seite, eine weitere Metallschicht, insbesondere eine Rückseitenmetallisierung und/oder ein Kühlelement vorgesehen ist. Dabei dient die Rückseitenmetallisierung vorzugsweise dazu, einer Durchbiegung entgegenzuwirken und das Kühlelement dient einem wirkungsvollen Abführen von Wärme, die im Betrieb von elektrischen bzw. elektronischen Bauteilen ausgeht, die an die Leiterplatte, bzw. das Metall-Keramik-Substrat angebunden sind.

Als Materialien für die mindestens eine Metallschicht und/oder die mindestens eine weitere Metallschicht im Metall-Keramik-Substrat bzw. Keramikelement sind Kupfer, Aluminium, Molybdän, Wolfram, Nickel und/oder deren Legierungen wie z. B. CuZr, AlSi oder AlMgSi, sowie Laminate wie CuW, CuMo, CuAl und/oder AlCu oder MMC (metal matrix composite), wie CuW, CuM oder AlSiC, vorstellbar. Weiterhin ist bevorzugt vorgesehen, dass die mindestens eine Metallschicht am gefertigten Metall-Keramik-Substrat, insbesondere als Bauteilmetallisierung, oberflächenmodifiziert ist. Als Oberflächenmodifikation ist beispielsweise eine Versiegelung mit einem Edelmetall, insbesondere Silber; und/oder Gold, oder (electroless) Nickel oder ENIG ("*electroless nickel immersion gold*") oder ein Kantenverguss an der Metallisierung zur Unterdrückung einer Rissbildung bzw. -weitung denkbar.

Vorzugsweise weist das Keramikelement Al₂O₃, Si₃N₄, AIN, eine HPSX-Keramik (d. h. eine Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25), SiC, BeO, MgO, hochdichtes MgO (> 90% der theoretischen Dichte), TSZ (tetragonal stabilisiertes Zirkonoxid) als Material für die Keramik auf. Es ist dabei auch vorstellbar, dass das Keramikelement als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einem Keramikelement zusammengefügt sind.

Vorzugsweise ist es vorgesehen, dass ein Abstand zwischen gegenüberliegenden Seitenwänden der mindestens einen ersten Metallschicht,
- zumindest bereichsweise kleiner als 0,4 mm, bevorzugt kleiner als 0,3 mm und besonders bevorzugt kleiner als 0,2 mm ist oder
- ein Wert annimmt, der zwischen 0,5 mm und 2,5 mm, bevorzugt zwischen 0,7 mm und 1,5 mm und besonders bevorzugt zwischen 0,8 mm und 1,2 mm liegt. Derart dünne Freiräume, die Abstände aufweisen, die kleiner sind als 0,2 mm, erweisen sich besonders anfällig für Verstopfungen, sodass hier eine entsprechend dünne Auftragung einer Korrosionsschutzschicht von Vorteil ist. Das Verfahren erweist sich allerdings auch als vorteilhaft für Kühlkanäle mit größerem Querschnitt bzw. größerer Öffnung.

Weiterhin ist bevorzugt vorgesehen, dass der Kühlkörper aus Kupfer und/oder Aluminium gefertigt ist.

Ein weiterer Gegenstand der vorliegenden Erfindung ist ein Verfahren zur Herstellung eines erfindungsgemäßen Trägerelements, wobei der Kühlkörper zu dessen Bildung und/oder zum Anbinden an eine Metallschicht und/oder an ein Keramikelement einer Temperatur oberhalb von 600 °C, bevorzugt oberhalb von 800 °C und besonders bevorzugt oberhalb von 1000 °C ausgesetzt wird. Dabei ist die Metallschicht, an die der Kühlkörper gebunden wird, bevorzugt die Rückseitenmetallisierung des Metall-Keramik-Substrats. Denkbar ist auch, dass der Kühlkörper direkt an das Keramikelement, insbesondere an dessen Kühlseite angebunden wird. Die für das Trägerelement beschriebenen Eigenschaften und Vorteile lassen sich analog übertragen auf das Verfahren.

Vorstellbar ist, dass die Korrosionsschutzschicht bei einer Temperatur zwischen 100 °C und 500 °C, bevorzugt zwischen 200° und 400° und besonders bevorzugt zwischen 250° und 350°C an die Innenseite des Kühlkanals angebunden wird. Vorzugsweise wird hierbei eine Restwärme nach dem Bindungsprozess der einzelnen Lagen zum Aushärten der Korrosionsschutzschicht verwendet.

Vorzugsweise ist es vorgesehen, dass die Korrosionsschutzschicht mittels gasphysikalischen Abscheidens auf dem Kühlkörper aufgetragen wird. Alternativ ist es vorstellbar, dass die Korrosionsschutzschicht durch ein Sol-Gel-Verfahren aufgetragen wird. Dabei ist es weiterhin vorstellbar, dass das gasphysikalische Abscheiden für die erste Metallschicht und die zweite Metallschicht vor dem Anbindungsverfahren erfolgt. Beispielsweise werden entsprechende Zwischenräume zwischenzeitlich mittels gasphysikalischen Abscheidens mit der Korrosionsschutzschicht versehen und nach dem Auftragen der Korrosionsschutzschicht erfolgt das Anbinden der mindestens ersten Metallschicht an die mindestens zweite Metallschicht. Dabei ist es vorstellbar, dass zumindest bereichsweise die aufgetragene Korrosionsschutzschicht wieder abgetragen wird, insbesondere in dem Bereich über die eine Anbindung zwischen der ersten Metallschicht und der zweiten Metallschicht erfolgen soll. Alternativ ist es vorstellbar, dass das Auftragen der Korrosionsschutzschicht erfolgt nachdem das Anbindungsverfahren durchgeführt worden ist. Dies erweist sich insbesondere dann deshalb als vorteilhaft, weil dadurch die Korngröße bereits erstellt ist, die sich als vorteilhaft für die Haftfähigkeit der Korrosionsschutzschicht an der Kühlstruktur herausgestellt hat.

Weiterhin ist es bevorzugt vorgesehen, dass die mindestens eine Metallschicht und/oder die mindestens eine weitere Metallschicht mittels eines Aktivlotverfahrens und/oder eines heißisostatischen Pressens und/oder eines DCB-Verfahrens an das Keramikelement angebunden wird.

Beispielsweise ist es vorgesehen, dass ein Verfahren zur Herstellung eines Metall-Keramik-Substrats vorgesehen ist, umfassend:
- Bereitstellen einer Lötschicht, insbesondere in Form mindestens einer Lötfolie bzw. Hartlotfolie,
- Beschichten des Keramikelements und/oder der mindestens einen Metallschicht und/oder der mindestens einen Lötschicht mit mindestens einer Aktivmetallschicht,
- Anordnen der mindestens einen Lötschicht zwischen dem Keramikelement und der mindestens einen Metallschicht entlang einer Stapelrichtung unter Ausbildung eines Lötsystems, das die mindestens eine Lötschicht und die mindestens eine Aktivmetallschicht umfasst, wobei ein Lotmaterial der mindestens einen Lötschicht vorzugsweise frei von einem schmelzpunkterniedrigenden Material bzw. von einem phosphorfreien Material ist, und
- Anbinden der mindestens einen Metallschicht an die mindestens eine Keramikschicht über das Lötsystem mittels eines Aktivlotverfahrens.

Insbesondere ist dabei ein mehrschichtiges Lötsystem aus mindestens einer Lötschicht, vorzugsweise frei von schmelzpunkterniedrigenden Elementen, besonders bevorzugt aus einer phosphorfreien Lötschicht, und mindestens einer Aktivmetallschicht, vorgesehen. Die Separation der mindestens einen Aktivmetallschicht und der mindestens einen Lötschicht erweist sich insbesondere deswegen als vorteilhaft, weil dadurch vergleichsweise dünne Lötschichten realisierbar sind, insbesondere wenn es sich bei der Lötschicht um eine Folie handelt. Für aktivmetallhaltige Lötmaterialien müssen andernfalls vergleichsweise große Lötschichtdicken wegen der spröden intermetallischen Phasen bzw. des hohen E-Moduls und hoher Streckgrenze der gängigen Aktivmetalle und deren intermetallischen Phasen, die die Umformung der Lötpaste bzw. Lötschicht behindern, realisiert werden, wodurch die minimale Schichtdicke durch die Fertigungseigenschaften des aktivmetallhaltigen Lötmaterials begrenzt wird. Entsprechend bestimmt für aktivmetallhaltige Lötschichten nicht die für das Fügeverfahren erforderliche Mindestdicke die minimale Lötschichtdicke der Lötschicht, sondern die für die technisch realisierbare minimale Schichtdicke der Lötschicht bestimmt die minimale Lötschichtdicke der Lötschicht. Dadurch ist diese dickere, aktivmetallhaltige Lötschicht teurer als dünne Schichten. Unter phosphorfrei versteht der Fachmann insbesondere, dass der Anteil an Phosphor in der Lötschicht kleiner ist als 150 ppm, kleiner als 100 ppm und besonders bevorzugt kleiner als 50 ppm.

Vorzugsweise umfasst die Lötschicht, insbesondere die phosphorfreie Lotschicht, mehrere Materialien zusätzlich zu dem reinen Metall. Beispielsweise ist Indium ein Bestandteil des verwendeten Lotmaterials in der Lötschicht.

Weiterhin ist es vorstellbar, dass das Lotmaterial zur Ausbildung der Lötschicht durch ein physikalisches und/oder chemisches Gasphasenabscheiden und/oder galvanisch auf die Aktivmetallschicht und/oder die mindestens eine Metallschicht aufgetragen wird. Dadurch ist es in vorteilhafter Weise möglich, vergleichsweise dünne Lotschichten im Lötsystem, insbesondere in einer homogenen Verteilung, zu realisieren.

Beispielsweise sind bei der Herstellung des Metall-Keramik-Substrats, insbesondere des Metall-Keramik-Substrats, weiteren Schritte vorgesehen, umfassend: - Bereitstellen eines Keramikelements und einer Metalllage,
- Bereitstellen eines gasdichten Behälters, der das Keramikelement umschließt, wobei der Behälter vorzugsweise aus der Metalllage geformt ist oder die Metalllage umfasst,
- Ausbilden des Metall-Keramik-Substrats durch ein Anbinden der Metalllage an das Keramikelement mittels heißisostatischem Pressen,
wobei zum Ausbilden des Metall-Keramik-Substrats zwischen dem der Metalllage und dem Keramikelement mindestens abschnittsweise eine Aktivmetallschicht oder eine ein Aktivmetall umfassende Kontaktschicht, zur Unterstützung des Anbindens der Metalllage an das Keramikelement, angeordnet wird. Der Behälter wird dabei vorzugsweise als Metallbehälter aus einer Metalllage und/oder einer weiteren Metalllage gebildet. Alternativ ist es auch vorstellbar, dass ein Glasbehälter verwendet wird.

Beim heißisostatischen Pressen ist es insbesondere vorgesehen, dass das Bonden durch Erhitzen unter Druck erfolgt, bei dem die erste und/oder zweite Metalllage des Metallbehälters, insbesondere die spätere Metallschicht des Metall-Keramik-Substrats und eine etwaige dort auftretende eutektische Schicht nicht in die Schmelzphase übertritt. In entsprechender Weise sind beim heißisostatischen Pressen geringere Temperaturen als bei einem Direktmetallanbindungsverfahren, insbesondere einem DCB-Verfahren, erforderlich.

Weitere Vorteile und Eigenschaften ergeben sich aus der nachfolgenden Beschreibung bevorzugter Ausführungsformen des erfindungsgemäßen Gegenstands mit Bezug auf die beigefügten Figuren. Es zeigt:
- **Fig. 1**:: schematische Explosionsdarstellung eines Trägerelements für eine beispielhafte Ausführungsform der vorliegenden Erfindung,
- **Fig. 2**: schematische Darstellung einer ersten Metallschicht für ein Kühlkörper aus Figur 1,
- **Fig. 3**: schematische Darstellung eines Trägerelements für eine weitere beispielhafte Ausführungsform der vorliegenden Erfindung,
- **Fig. 4 bis Fig. 8**:: detaillierte Darstellung eines Systems aus dem Trägerelement mit einer Verteilstruktur und
- **Fig. 9**: schematische Darstellung einer Korrosionsschutzschicht auf einem Kühlkörper

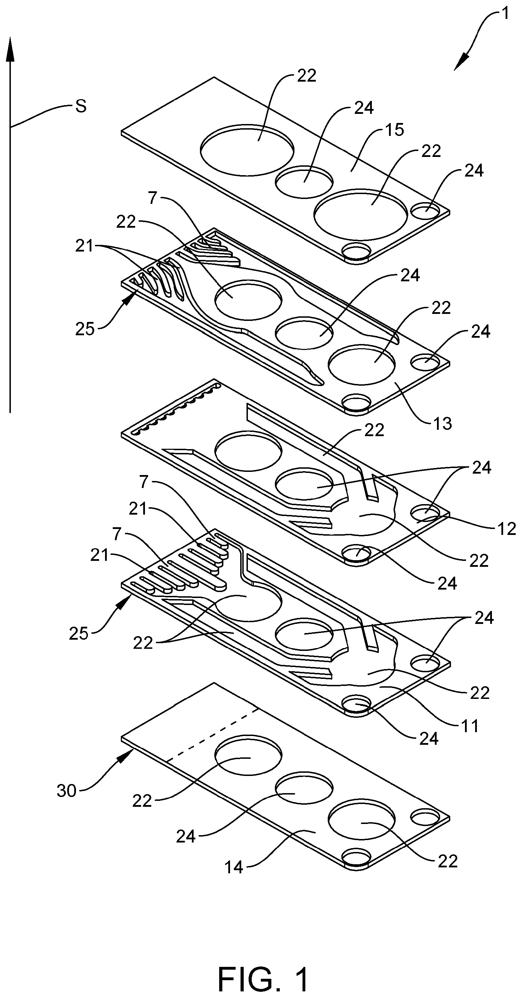

In **Figur 1** ist schematisch eine Explosionsdarstellung eines Kühlkörpers 1 gemäß einer ersten bevorzugten Ausführungsform der vorliegenden Erfindung dargestellt. Insbesondere handelt es sich bei dem Kühlkörper 1 um ein solches, das zum Kühlen eines elektronischen oder elektrischen Bauteils (nicht dargestellt), insbesondere eines Halbleiterelements und besonders bevorzugt einer Laserdiode, vorgesehen ist. Zum Kühlen des elektrischen bzw. des elektronischen Bauteils bildet das gefertigte Kühlkörper 1 ein Kühlfluidkanalsystem aus, durch das im Betrieb ein Kühlfluid leitbar ist, so dass das Kühlfluid Wärme, die von dem elektronischen bzw. elektrischen Bauteil im Betrieb ausgeht, aufnehmen und wegführen kann.

Hierzu sind in dem Kühlkörper 1, insbesondere im Kühlfluidkanalsystem, vorzugsweise ein Zuleitungsbereich und ein Ableitungsbereich vorgesehen (nicht gezeigt), wobei über den Zuleitungsbereich das Kühlfluid eingeleitet wird und über den Ableitungsbereich wieder ausgeleitet wird. Vorzugsweise ist es vorgesehen, dass das Kühlfluidkanalsystem derart ausgestaltet ist, dass das Kühlfluid 1 beim Übergang vom Zuleitungsbereich zum Ableitungsbereich eine Finnenstruktur 25 passiert, die insbesondere in das Kühlfluidkanalsystem hineinragt. Bei der Finnenstruktur 25 handelt es sich vorzugsweise um stegartige Elemente 7 die in das Kühlfluidkanalsystem hineinragen, um eine möglichst große Kontaktfläche für das Fluid bereitzustellen, sodass eine wirkungsvolle Übertragung der Wärme vom stegartigem Element 7 bzw. der Wandung des Kühlkanalsystems auf das Fluid möglich ist.

Vorzugsweise umfasst das Kühlkörper 1 mindestens eine erste Metallschicht 11, mindestens eine zweite Metallschicht 12 und/oder mindestens eine dritte Metallschicht 13. Zur Ausbildung des Kühlfluidkanalsystems sind die mindestens eine erste Metallschicht 11, die mindestens zweite Metallschicht 12 und/oder die mindestens dritte Metallschicht 13 durch mindestens eine Ausnehmung 21, 22 derart strukturiert, dass sie durch ein Aufeinanderstapeln bzw. ein übereinanderlegen entlang der Stapelrichtung S das Kühlfluidkanalsystem ausbildet.

Dabei ist es insbesondere vorgesehen, dass die mindestens eine erste Metallschicht 11, die mindestens eine zweite Metallschicht 12 und/oder die mindestens eine dritte Metallschicht 13 jeweils anders strukturiert sind bzw. mit anders verlaufenden Ausnehmungen 21, 22 ausgestattet sind. Insbesondere ist es vorgesehen, dass die mindestens eine erste Metallschicht 11, die mindestens eine zweite Metallschicht 12 und/oder die mindestens eine dritte Metallschicht 13 mindestens einen ersten Teil 21 in der mindestens einen Ausnehmung 21, 22 ausformt, der die stegartigen Elemente 7 aufweist, die insbesondere sich in einer senkrecht zur Stapelrichtung S verlaufenden Haupterstreckungsebene HSE erstrecken. Neben dem ersten Teil 21 der mindestens einen Ausnehmung 21, 22 in der mindestens einen ersten Metallschicht 11 ist es vorzugsweise vorgesehen, dass ein zweiter Teil 22 der mindestens einen Ausnehmung 21, 22 in der mindestens einen ersten Metallschicht 11 für das Zuleiten oder Ableiten des Kühlfluides in den ersten Teil 21 bzw. aus dem ersten Teil 21 vorgesehen ist bzw. einen Teil des Zuleitungsbereich und/oder Ableitungsbereichs bildet.

Das Kühlkörper 1 wird vorzugsweise in Stapelrichtung S durch eine obere Deckschicht 15 und eine untere Deckschicht 14 begrenzt, wobei die erste mindestens eine erste Metallschicht 11, die mindestens eine zweite Metallschicht 12 und/oder die mindestens eine dritte Metallschicht 13 in Stapelrichtung S gesehen zwischen der unteren Deckschicht 14 und der oberen Deckschicht 15 angeordnet ist. Insbesondere ist die Formation aus der mindestens einen ersten Metallschicht 11, der mindestens einen zweiten Metallschicht 12 und/oder der mindestens einen dritten Metallschicht 13 sandwichartig zwischen der oberen Deckschicht 15 und der unteren Deckschicht 14 angeordnet. Neben der mindestens einen Ausnehmung 21, 22, die sich zusammensetzt aus dem ersten Teil 21 und dem zweiten Teil 22, ist es vorzugsweise vorgesehen, dass das Kühlkörper 1 bzw. die mindestens eine erste Metallschicht 11 eine weitere Ausnehmung 24 aufweist, die kein Bestandteil des Kühlfluidkanalsystems, mit der Finnenstruktur 25 ist. Weiterhin ist es vorzugsweise vorgesehen, dass an der oberen Deckschicht 15 und/oder der unteren Deckschicht 14 eine Anschlussfläche 30 vorgesehen ist. Insbesondere wird an dieser Anschlussfläche 30 das elektrische bzw. elektronische Bauteil angebunden, insbesondere in Stapelrichtung S gesehen, oberhalb bzw. unterhalb der Finnenstruktur 25, die sich vorzugsweise in einer senkrecht zur Stapelrichtung S verlaufenden Richtung erstreckt. Mit anderen Worten: die Finnenstruktur 25, insbesondere deren stegartigen Elemente 7, erstreckt sich unterhalb der Anschlussfläche 30 und vorzugsweise parallel dazu. Durch die entsprechende Anordnung der Finnenstruktur 25 aus den stegartigen Elementen 7 oberhalb bzw. unterhalb der Anschlussfläche 30 lässt sich das elektrische bzw. das elektronische Bauteil wirkungsvoll mittels der Finnenstruktur 25 kühlen.

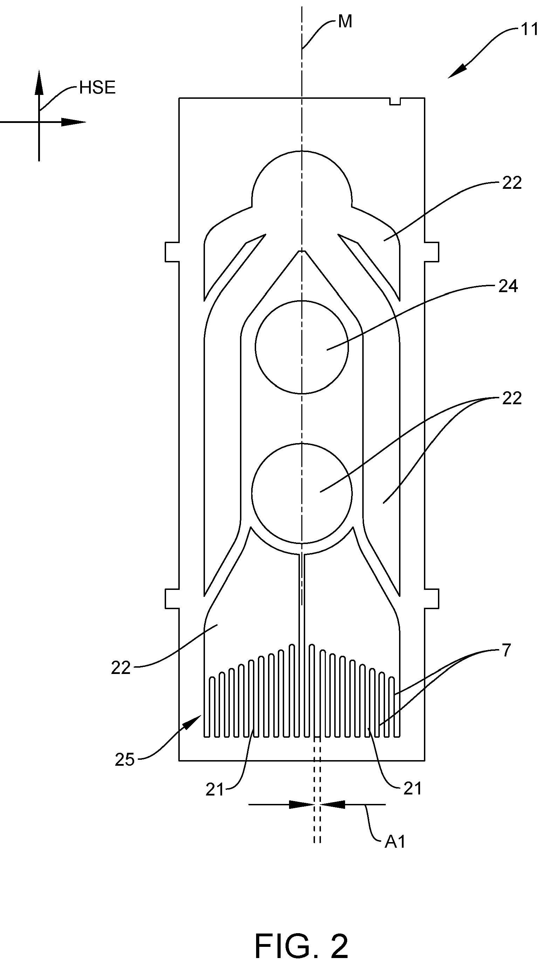

In **Figur 2** ist eine schematische Darstellung einer mindestens einen ersten Metallschicht 11 dargestellt, die beispielsweise in Figur 1 verbaut ist. In der dargestellten Ausführungsform ist die Finnenstruktur 25 aus stegartigen Elementen 7 ausgebildet, die sich in Haupterstreckungsebene HSE gesehen, unterschiedlich weit erstrecken. Insbesondere nimmt eine Länge der stegartigen Elemente 7 zu einer Mittelachse M der mindestens einen ersten Metallschicht 11 zu. Dadurch ist es in vorteilhafter Weise möglich, die Kühlwirkung insbesondere im Zentralbereich der Anschlussfläche 30 möglichst zu maximieren. Ferner ist es vorstellbar, dass die stegartigen Elemente parallel und/oder schräg zur Mittelachse M verlaufen. Vorzugsweise wird die Form der stegartigen Elemente 7 insbesondere deren Länge und/oder Neigung gegenüber der Mittelachse M entlang der Haupterstreckungsebene HSE durch das entsprechende Anforderungsprofil für das Kühlen des entsprechenden elektrischen oder elektronischen Bauteils bestimmt bzw. festgelegt.

Um einen möglichst geringen Abstand A1 zwischen zwei benachbarten stegartigen Elementen 7 zu erzielen, ist es beispielsweise vorgesehen, dass der erste Teil 21 der mindestens einen Ausnehmung 21, 22 in der mindestens einen ersten Metallschicht 11 durch ein Erodieren, insbesondere Funkenerodieren, erfolgt. Insbesondere handelt es sich dabei um ein Herstellen mittels Drahterodieren.

Ferner ist es vorgesehen, dass ein zweiter Teil 22 der mindestens einen Ausnehmung 21, 22 durch ein Ätzen erfolgt. Vorzugsweise wird das Ätzen insbesondere in großflächigen Bereichen des zweiten Teils 22 der Ausnehmung 21, 22 durchgeführt, d. h. in den späteren Zuführ- und/der Ableitbereichen, die für das Zuführen und das Ableiten des Kühlfluids ausgebildet sind. Im Gegensatz dazu ist es insbesondere vorgesehen, dass das Erodieren für die feinstrukturierte Ausformung der Ausnehmung 21, 22, d. h. den ersten Teil 21 der Ausnehmung 21, 22 vorgesehen ist. Es hat sich herausgestellt, dass dadurch vergleichsweise sehr geringe Abstände zwischen den stegartigen Elementen 7 hergestellt werden können, ohne dass man auf mehrere erste Metallschichten 11 mit geätzten ersten Teilen 21 der mindestens einen Ausnehmung 21, 22 angewiesen wäre, die übereinander gestapelt werden müssten, um einen möglichst geringen Abstand zwischen zwei stegartigen Elementen 7 zu realisieren. Vorzugsweise ist der Abstand A1 zwischen gegenüberliegenden Seitenwänden zwischen zwei stegartigen Elementen 7 kleiner als 0,4 mm, bevorzugt kleiner als 0,3 mm und besonders bevorzugt kleiner als 0,2 mm. Dadurch lassen sich möglichst viele stegartige Elemente 7 in die Finnenstruktur 25 integrieren. Entsprechend ist es möglich, die Kühlwirkung zu erhöhen, da die Kontaktfläche zwischen Kühlfluid und Wandlung des Kühlfluidkanalsystems in entsprechender Weise erhöht werden kann.

Vorzugsweise weisen die mindestens eine erste Metallschicht 11, die mindestens eine zweite Metallschicht 12, die mindestens eine dritte Metallschicht 13, die obere Deckschicht 15 und/oder die untere Deckschicht 14 eine in Stapelrichtung S gemessene Dicke zwischen 0,2 und 0,7 mm, bevorzugt zwischen 0,35 und 0,6 mm und besonders bevorzugt zwischen 0,3 und 0,4 mm auf. Vorzugsweise bilden die mindestens eine erste Metallschicht 11, die mindestens eine zweite Metallschicht 12 und/oder die mindestens eine dritte Metallschicht 13 jeweils dieselbe Dicke aus. Weiterhin ist es bevorzugt vorgesehen, dass die mindestens eine erste Metallschicht 11, die mindestens eine zweite Metallschicht 12 und/oder die mindestens eine dritte Metallschicht 13 im Rahmen eines Sinterverfahrens zu einem integralen Kühlfluidkanalsystem geformt werden, indem durch eine entsprechende Temperaturbehandlung die Gefüge der mindestens einen ersten Metallschicht 11, der mindestens einen zweiten Metallschicht 12 und/oder der mindestens einen dritten Metallschicht 13 ineinander übergehen bzw. miteinander verschmelzen. Weiterhin ist es vorgesehen, dass auch die obere Deckschicht 15 und/oder die untere Deckschicht 14 jeweils mindestens eine Ausnehmung 21, 22 und/oder eine weitere Ausnehmung 24 aufweisen, wobei die obere Deckschicht 15 und/oder die untere Deckschicht 14 vorzugsweise frei sind von stegartigen Elementen 7 bzw. Bestandteilen einer späteren Finnenstruktur 25. Die weiteren Ausnehmungen 24 dienen vorzugsweise der Befestigung oder Fixierung des Kühlelements 1.

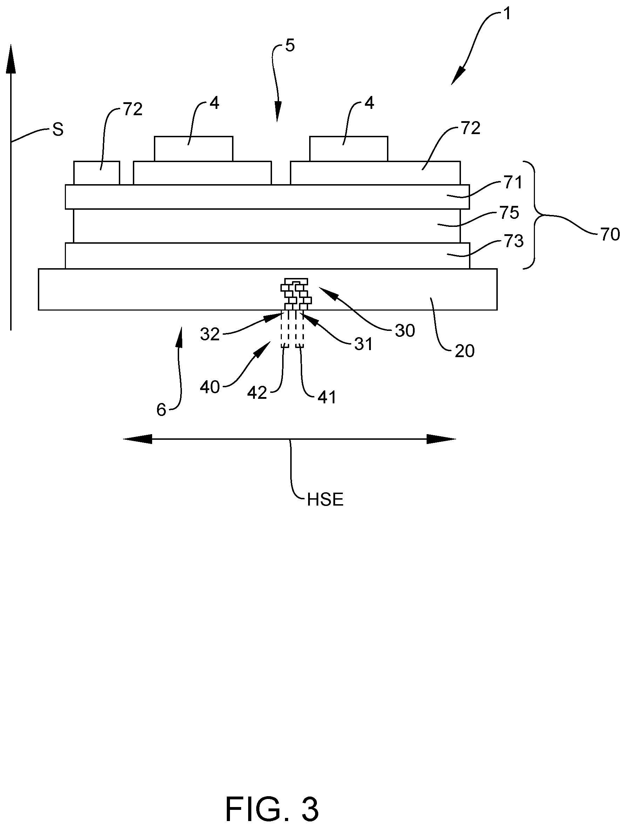

In **Figur 3** ist schematisch ein Metall-Keramik-Substrat 70 gemäß einer weiteren beispielhaften Ausführungsform der vorliegenden Erfindung dargestellt. Solche Metall-Keramik-Substrate 1 dienen vorzugsweise als Träger von elektronischen bzw. elektrischen Bauteile 4, die an das Metall-Keramik-Substrat 70 anbindbar sind. Wesentliche Bestandteile eines solchen Metall-Keramik-Substrats 1 sind eine sich entlang einer Haupterstreckungsebene HSE erstreckendes Keramikelement 71 und eine an der Keramikschicht 71 angebundene Bauteilmetallisierung 72. Das Keramikelement 71 ist aus mindestens einem eine Keramik umfassenden Material gefertigt. Die Bauteilmetallisierung 72 und das Keramikelement sind dabei entlang einer senkrecht zur Haupterstreckungsebene HSE verlaufenden Stapelrichtung S übereinander angeordnet und miteinander stoffschlüssig verbunden. Im gefertigten Zustand ist die Bauteilmetallisierung 72 auf einer Bauteilseite 5 des Metall-Keramik-Substrats 70 zur Bildung von Leiterbahnen oder Anbindungsstellen für die elektrischen Bauteile 4 strukturiert. In der dargestellten Ausführungsform umfasst das Metall-Keramik-Substrat 70 eine Sekundärschicht 73 und eine zwischen dem Keramikelement 71 und der Sekundärschicht 73 angeordnete metallische Zwischenschicht 75. Das Keramikelement 71, die metallische Zwischenschicht 75 und die Sekundärschicht 13 sind entlang der Stapelrichtung S übereinander angeordnet. Ferner ist es vorgesehen, dass die metallische Zwischenschicht 75 dicker ist als das Keramikelement 71 und/oder die Sekundärschicht 73. Vorzugsweise ist die metallische Zwischenschicht 75 dicker als 1 mm, bevorzugt dicker als 1,5 mm und besonders bevorzugt dicker als 2,5 mm. Es ist aber auch vorstellbar, dass zur Ausbildung des Metall-Keramik-Substrats lediglich ein Keramikelement 71 mit einer Bauteilmetallisierung 72 und einer Rückseitenmetallisierung ausgebildet ist. Während das Keramikelement 71 bevorzugt aus Keramik ist und zur Ausbildung einer ausreichenden Isolationsfestigkeit und zur Versteifung des Metall-Keramik-Substrats 1 ausgelegt ist, kann die Sekundärschicht 73 beispielsweise auch aus Wolfram oder Molybdän sein, da hier keine ausgeprägte Isolationsfestigkeit erforderlich ist. So lassen sich die Materialkosten senken. Alternativ ist die Sekundärschicht 73 ebenfalls aus einem eine Keramik umfassenden Material gefertigt.

Auf einer der Bauteilseite 5 gegenüberliegenden Kühlseite 6 des Metall-Keramik Substrats 1 ist ein metallischer Kühlkörper 20 vorgesehen. Der metallische Kühlkörper 20 ist vorzugsweise unmittelbar an die Sekundärschicht 73 angebunden. Es ist aber auch vorstellbar, dass der Kühlkörper 20 direkt an eine Rückseitenmetallisierung des Metall-Keramik-Substrats 1 oder an das Keramikelement 71 des Metall-Keramik-Substrats 1 angebunden ist. Dadurch lässt sich vermeiden, dass eine sich andernfalls ausbildende Grenzfläche mit einem entsprechenden Verbindungsmaterial negativ auf die Wärmleitfähigkeit und somit einschränkend auf einen Wärmeabtransport von der Bauteilseite 5 zur Kühlseite 6 auswirkt.

Beispielsweise ist die Kühlstruktur 20 über ein AMB-Verfahren, ein DCB (direct copper bonding)- oder DAB (direct aluminium bonding)- Verfahren unmittelbar an die Sekundärschicht 73, die Rückseitenmetallisierung und/oder an das Keramikelement 71 angebunden. Insbesondere ist es vorgesehen, dass in die metallische Kühlstruktur 20 eine Vielzahl von Fluidkanälen 30 integriert ist. Der Übersicht halber ist in Figur 1 beispielhaft nur ein einzelner dieser Fluidkanäle 30 eingezeichnet. Die Fluidkanäle 30 dienen einer gezielten Führung eines Fluids, insbesondere eines Kühlfluids, innerhalb der metallischen Kühlstruktur 20. Der Kühlstruktur 20 wird das Fluid über ein Verteilstruktur 40 zugeführt und über die Verteilstruktur 40 wieder abgeführt. Vorzugsweise weist die Verteilstruktur 40 hierzu einen einleitenden Teil 41 und einen ableitenden Teil 42 auf.

Insbesondere weist der Fluidkanal 30 eine Eingangsöffnung 31 und eine von der Eingangsöffnung 31 beabstandete Ausgangsöffnung 32 auf. Dabei sind die Eingangsöffnung 31 und die Ausgangsöffnung 32 Teil einer der Verteilstruktur 40 zugewandten Außenseite A der Kühlstruktur 20. Insbesondere grenzt der einleitende Teil 31 der Verteilstruktur 40 an die Eingangsöffnung 31 und der ableitenden Teil 42 an die Ausgangsöffnung 32 an.

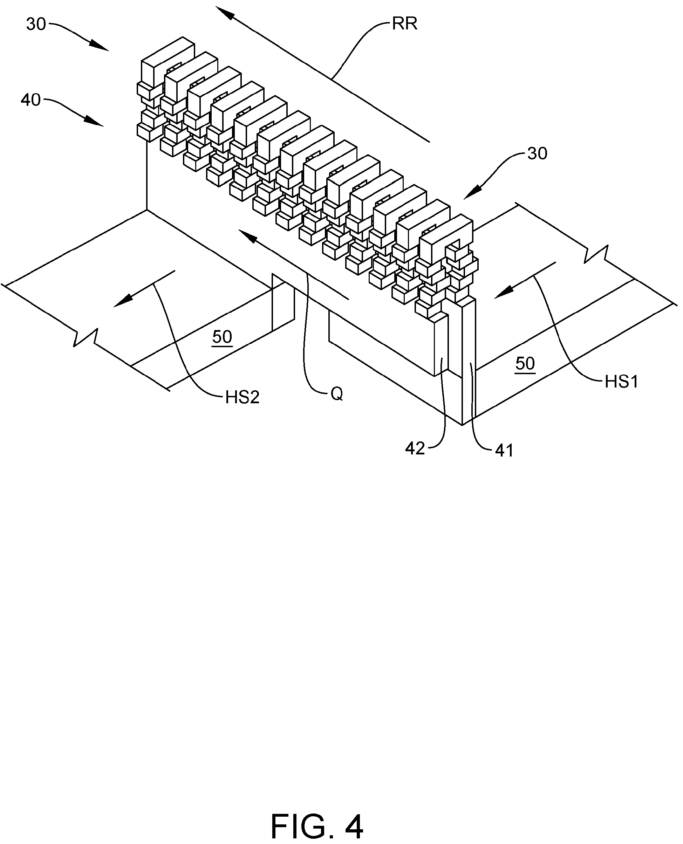

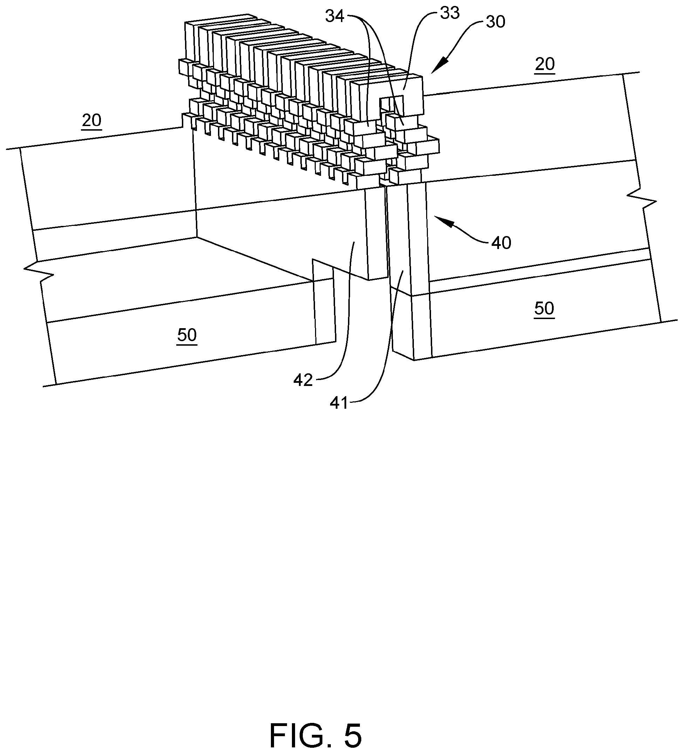

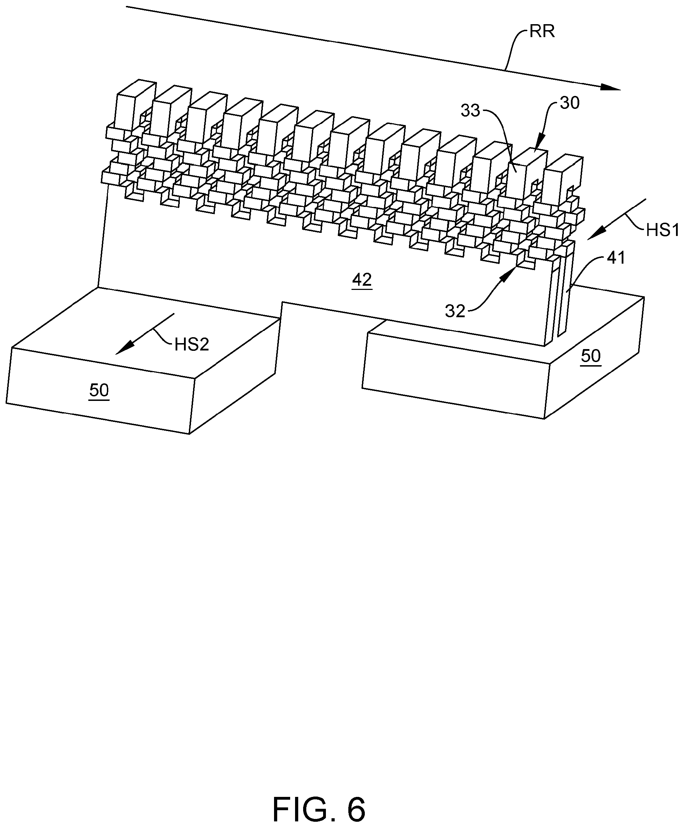

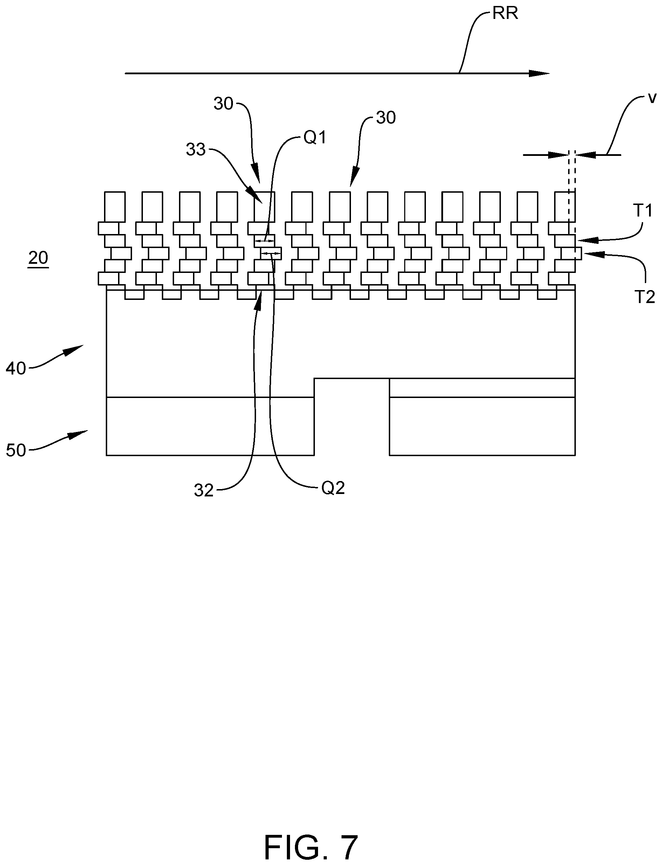

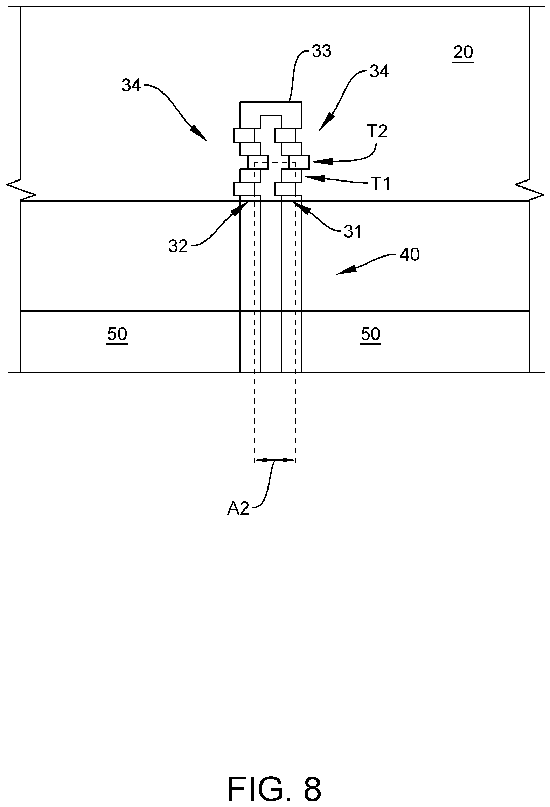

In den **Figuren 4 bis 6** sind jeweils nur die metallische Kühlstruktur 20 und die Verteilstruktur 40 in perspektivischen Darstellungen und in den Figuren 7 und 8 in zwei verschiedenen Seitenansichten dargestellt. Dabei sind in den Figuren - statt der gesamten Kühlstruktur 20 - die mehreren Fluidkanäle 30 der Kühlstruktur 20 dargestellt. Mit anderen Worten: Hier sind die Fluidkanäle 30 ohne den metallischen Körper dargestellt, in den sie eingelassen sind. In Stapelrichtung S gesehen schließt ferner an der Unterseite der Verteilstruktur 40 eine Zuführstruktur 50 an. Demnach ist in Stapelrichtung S gesehen, die Verteilstruktur zwischen der Kühlstruktur und der Zuführstruktur angeordnet. Solch eine Zuführstruktur 50 ist vorzugsweise dazu vorgesehen, eine erste Hauptströmungsrichtung HS1 vorzugeben. Beispielsweise ist die Zuführstruktur kanalförmig ausgebildet. Ferner umfasst die Zuführstruktur 50 mindestens einen Einlass und einen Auslass (hier nicht dargestellt) an die ein Fluidkreislauf angeschlossen werden kann bzw. eine Kühlfluidversorgung und eine Kühlfluidentsorgung. Die Verteilstruktur 40 ist dabei vorzugsweise derart ausgestaltet, dass sie das Fluid aus einem entlang der ersten Hauptströmungsrichtung HS1 fließende Strom heraus in die Kühlstruktur 20 umlenkt bzw. dort einleitet. Weiterhin zeigen die Figuren der Übersicht halber lediglich ein einzelne Reihe Fluidkanälen 30. Bevorzugt ist es vorgesehen, dass mehrere Reihen in einer senkrecht zur Reihenrichtung RR und parallel zur Haupterstreckungsebene HSE verlaufenden Richtung nebeneinander bzw. hintereinander angeordnet sind und jede dieser Reihen wird über eine entsprechende Verteilstruktur 40, beispielswiese eine einzelne Verteilstruktur, mit dem Fluid versorgt. Vorzugsweise erstrecken sich diese mehrere Reihen vollständig über die der Verteilstruktur zugewandten Außenseite A der Kühlstruktur 20.

Insbesondere ist es vorgesehen, dass mehrere Fluidkanäle 30 nebeneinander angeordnet sind. Insbesondere sind in der dargestellten Ausführungsform die Fluidkanäle 30 entlang einer Reihe angeordnet, die im dargestellten Ausführungsbeispiel im Wesentlichen senkrecht zur ersten Hauptströmungsrichtung HS1 verläuft. Grundsätzlich ist es auch vorstellbar, dass die Reihe entlang einer Reihenrichtung RR verläuft, die gegenüber der ersten Hauptströmungsrichtung HS1 um einen Winkel zwischen 0 und 90° geneigt ist. Vorzugsweise ist der Winkel kleiner 45°.

In dem in den **Figuren 4 bis 8** dargestellten Ausführungsbeispiel ist es vorgesehen, dass die Verteilstruktur 40 das Fluid so umlenkt, dass zumindest ein Teil des Fluid zunächst von einer ersten Hauptströmungsrichtung HS1 in eine parallel zur Reihenrichtung verlaufende Querrichtung Q umgelenkt wird, bevor es in die Eingangsöffnungen 31 geleitet wird. Zusätzlich wird das Fluid in Richtung der Eingangsöffnung 31 in Richtung der Kühlstruktur 20, d. h. nach oben, umgelenkt. Dadurch kann die Verteilstruktur mehrere Eingangsöffnungen 31 verschiedener Fluidkanäle 30 mit einem gleichtemperierten Fluid versorgen. Hierzu ist der einleitende Teil 41 als wandartige Struktur ausgebildet, die im dargestellten Ausführungsbeispiel im Wesentlichen parallel zur Reihenrichtung RR verläuft. Bevorzugt ist es vorgesehen, dass die Zuführstruktur 50 das Fluid nur einem Teil der Verteilstruktur 40 zuführt. Im dargestellten Ausführungsbeispiel wird entlang der ersten Hauptströmungsrichtung HS1 gesehen im Wesentlichen ein erster Teil, insbesondere eine linke Hälfte, des einleitenden Teils 41 durch das Kühlfluid angeströmt. Mittels der Verteilstruktur 40 wird aber die vollständige Reihe von Fluidkanälen 30 mit dem Fluid versorgt. Vorzugsweise umfasst der einleitenden Teil eine rampenartige Struktur, die in Reihenrichtung RR gesehen geneigt ist, insbesondere gegenüber der Haupterstreckungsebene HSE geneigt ist.

Nach dem Durchtritt durch die Fluidkanäle 30 verlässt das Fluid die Kühlstruktur 20 über die Ausgangsöffnungen 32 und wird in den ausleitenden Teil 42 der Verteilstruktur geführt. Der ausleitende Teil 42 der Verteilstruktur 40 ist ebenfalls als wandartige Struktur ausgestaltet, die im Wesentlichen parallel zur Reihenrichtung RR verläuft. Insbesondere ist es vorgesehen, dass der ausleitenden Teil 42 so gestaltet ist, dass er das aus den Ausgangsöffnungen tretenden Fluid sammelt und in eine zweite Hauptströmungsrichtung HS2 zurück in die Zuführstruktur 50 umlenkt. Beispielsweise umfasst der ausleitende Teil 42 eine rampenartige Struktur die in Reihenrichtung RR geneigt ist, insbesondere entgegengesetzt geneigt zur rampenartigen Struktur im einleitenden Teil 41 der Verteilstruktur 40. Ferner ist es vorgesehen, dass die erste Hauptströmungsrichtung HS1 und die zweite Hauptströmungsrichtung HS2 parallel zueinander versetzt sind. Mit anderen Worten: Nach dem Verlassen der Verteilstruktur 40 ist die Strömung des Fluid seitlich bzw. lateral versetzt gegenüber der Strömung beim Anströmen der Verteilstruktur 40.

In der dargestellten Ausführungsform ist der einleitenden Teil 41 der Verteilstruktur 40 entlang der ersten Hauptströmungsrichtung HS1 gesehen vor dem ausleitenden Teil 42 der Verteilstruktur 40 angeordnet. Es ist aber auch vorstellbar, dass der ausleitende Teil 42 entlang der ersten Hauptströmungsrichtung HS1 gesehen vor dem einleitenden Teil 31 der Verteilstruktur 40 angeordnet ist.

Die einzelnen Fluidkanäle 30 sind bevorzugt U-Förmig gestaltet, wobei der U-förmig gestaltete Fluidkanal 30 zwei im Wesentlichen senkrecht zur Haupterstreckungsebene HSE verlaufende Schenkelbereiche 34 und einen die beiden Schenkelbereiche 34 verbindenden Querbereich 33 aufweist. Insbesondere dient der Querbereich 33 dem Umlenken des Fluid und ist im verbauten Zustand der Sekundärschicht 13 bzw. der Keramikschicht 11 am nächsten. Vorzugsweise nimmt eine Distanz zwischen dem Querbereich 33 und einer an die Kühlstruktur 20 angrenzende Keramikschicht 11 bzw. Sekundärschicht 13 einen Wert zwischen 0,2 und 1,5 mm, bevorzugt zwischen 0,4 und 1 und besonders bevorzugt zwischen 0,6 mm und 0,8 mm an. Vorzugsweise sind die Fluidkanäle 30, insbesondere deren Schenkelbereiche 34 so gestaltet, dass das Fluid innerhalb der Fluidkanäle 30 verwirbelt wird. Hierzu ist es beispielsweise vorgesehen, dass sich ein parallel zur Haupterstreckungsebene HSE verlaufender Öffnungsquerschnitt Q1, Q2 der Schenkelbereiche 34 entlang einer Strömungsrichtung des Fluid innerhalb des Fluidkanals 30, insbesondere innerhalb des Schenkelbereichs 34, seitlich verlagert. Dabei umfasst der Schenkelbereich 34 einen ersten Teilabschnitt T1 mit einem ersten Öffnungsquerschnitt Q1 und einen zweiten Teilabschnitt T2 mit einem zweiten Öffnungsquerschnitt Q2, wobei der erste Öffnungsquerschnitt Q1 zum zweiten Öffnungsquerschnitt Q2 in einer parallel zur Haupterstreckungsebene HSE verlaufenden Richtung gesehen um einen Versatzabstand V versetzt ist. Vorzugsweise sind der ersten Öffnungsquerschnitt Q1 und der zweite Öffnungsquerschnitt Q2 gleich groß. Es ist aber auch vorstellbar, dass sich der erste Öffnungsquerschnitt vom zweiten Öffnungsquerschnitt unterscheidet. Insbesondere sind der erste Teilabschnitt T1 und der zweite Teilabschnitt T2 jeweils Metalllagen zugeordnet, die beispielsweise bei der Fertigung übereinandergestapelt werden. Dabei können die einzelnen Metalllagen gleich dick sein oder sich bezüglich ihrer Dicke unterscheiden. Es ist beispielsweise auch vorstellbar, dass die Dicke der einzelnen Ebenen in Richtung der Bauteilseite ab- und/oder zunimmt.

Insbesondere ist es vorgesehen, dass der erste Öffnungsquerschnitt Q1 und der zweite Öffnungsquerschnitt Q2 in einer parallel zur ersten Hauptströmungsrichtung HS1 bzw. zweiten Hauptströmungsrichtung HS2 und einer parallel zur Reihenrichtung RR, d. h. in zwei zueinander nicht parallel verlaufenden Richtungen, zueinander versetzt sind. Vorzugsweise nimmt ein Verhältnis eines Überlappbereichs, in dem der ersten Öffnungsquerschnitt Q1 und der zweite Öffnungsquerschnitt Q2 in Stapelrichtung S gesehen übereinander angeordnet sind, und dem ersten Öffnungsquerschnitt Q1 bzw. dem zweiten Öffnungsquerschnitt Q2 einen Wert zwischen 0,5 und 0,9, bevorzugt zwischen 0,5 und 0,8 und besonders bevorzugt zwischen 0,5 und 0,7 an. Vorstellbar ist insbesondere dass der Öffnungsquerschnitt der Eingangsöffnung und/oder der Ausgangsöffnung größer ist als der erste Öffnungsquerschnitt und/oder der zweite Öffnungsquerschnitt. Dadurch lässt sich ein trichterartiger Eingangsbereich und Ausgansbereich für den Fluidkanal bilden.

Es ist aber auch vorstellbar, dass der erste Öffnungsquerschnitt Q1 und der zweite Öffnungsquerschnitt Q2 unterschiedlich groß sind. Bevorzugst sind erste und zweite Öffnungsquerschnitte derart ausgestaltet, dass sie einen im Wesentlichen spiralförmigen Verlauf für den Fluidkanal 30 bilden. Die Fluidkanäle 30 lassen sich beispielsweise durch ein Aufeinanderschichten von Metallschichten, d. h. zumindest einer ersten Metallschicht 11 und einer zweiten Metallschicht 12, mit entsprechenden Öffnungen oder durch ein 3D Druckverfahren realisieren. Weiterhin ist es vorgesehen, dass die Eingangsöffnung 13 einen ersten Öffnungsquerschnitt aufweist, dessen Durchmesser und/oder Kantenlänge einen Wert zwischen 0,1 mm und 2,5 mm, bevorzugt zwischen 0,5 mm und 1,5 mm und bevorzugt im Wesentlichen von 1 mm aufweist. Dabei ist es bevorzugt vorgesehen, dass sich der erste Öffnungsquerschnitt Q1 bzw. der zweite Öffnungsquerschnitt Q2 innerhalb der Schenkelbereiche 34 des Fluidkanals 30 nicht ändern.

Weiterhin ist es vorgesehen, dass ein weitere Abstand A2 zwischen zweier benachbarter Schenkelbereiche, bevorzugt desselben Fluidkanals, einen Wert zwischen 0,1 mm und 5 mm, bevorzugt zwischen 0,2 mm und 2 mm und besonders bevorzugt im Wesentlichen 1,5 mm annimmt. Dabei wird der weiterer Abstand A2 zwischen zwei Mitten der ersten Querschnittsöffnung Q1 bzw. zweiten Querschnittsöffnungen Q2 auf derselben Höhe in Stapelrichtung S gesehen gemessen.

Neben den oben beschriebenen Kühlkörpern 20 bzw. Trägerelementen 1 sind auch weitere Kühlkörper 20 mit unterschiedlichen Geometrien vorstellbar. Beispielsweise ist sogar denkbar, dass der Kühlkörper 20 aus einem im Wesentlichen flachen, unstrukturierten Metallkörper 20 gebildet wird. Bevorzugt ist allerdings ein strukturierter Kühlkörper 20, der beispielsweise zu seiner Kühlseite offen und/oder zumindest teilweise geschlossen oder vollständig geschlossen ist. Vorzugsweise bilden sich Mikrokanäle im gefertigten Kühlkörper 20 aus, durch die dann im Betrieb ein Kühlfluid, vorzugsweise eine Kühlflüssigkeit, geführt werden kann. Dadurch lässt sich die entstandene Wärme, beispielsweise auf der Bauteilseite 4 oder hervorgerufen durch eine Laserdiode, die an die Anschlussfläche 30 montiert ist, abführen. Um zu verhindern, dass mit der Zeit der aus einem Metall gefertigte Kühlkörper 20 korrodiert, ist es vorgesehen, dass der Kühlkörper 20 zumindest teilweise eine Korrosionsschutzschicht 30 aufweist. Andernfalls würde eine entsprechende Korrosion dazu führen, dass der Kühlkörper 20 entweder undicht wird und/oder die Mikrokanäle bzw. Kühlbereiche verstopfen.

Dabei hat es sich als besonders vorteilhaft erwiesen, die Korrosionsschutzschicht 30 an solchen Kühlkörpern 20 vorzusehen, die während ihres Herstellungsverfahrens einer Temperatur von mehr als 600 °C, vorzugsweise mehr als 800 °C und besonders bevorzugt mehr als 1000 °C ausgesetzt wurden. In Folge einer solchen Temperaturbehandlung entstehen nämlich Körnung mit einer durchschnittlichen Korngröße in einem Bereich zwischen 10 µm und 800 µm, bevorzugt zwischen 100 µm und 700 µm und besonders bevorzugt zwischen 300 µm und 600 µm . Diese Körnung führt dazu, dass an einer Außenseite bzw. Oberfläche, an die die Korrosionsschutzschicht 30 angebunden wird, wodurch eine besonders vorteilhafte Kontakt- und Haftfläche bereitgestellt wird, die das Haftvermögen der Korrosionsschutzschicht 30 erhöht. Eine solche Körnung trifft bevorzugt bei solchen Kühlstrukturen bzw. Kühlkörpern 20 auf, die beispielsweise im Rahmen eines Lötverfahrens oder im Rahmen eines Direktanbindungsverfahrens oder eines Diffusionsbondverfahrens dadurch gebildet werden, dass mehrere Metallschichten, d. h. eine erste Metallschicht 21 und eine zweite Metallschicht 21, miteinander verbunden werden und/oder dadurch dass der Kühlkörper 20 im Rahmen eines DCB-Verfahrens oder Lötverfahrens oder eines Diffusionsbondverfahren an ein Keramikelement und/oder eine Rückseitenmetallisierung eines Metall-Keramik-Substrats 70 angebunden wird.

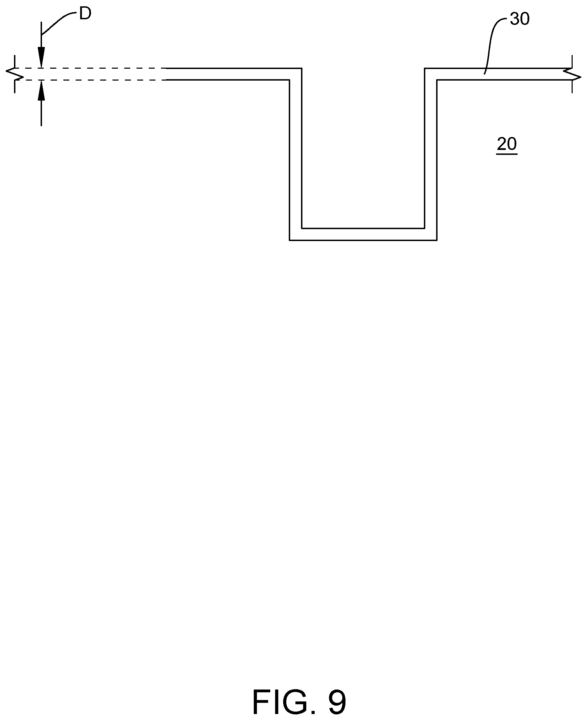

In **Figur 9** ist eine solche Korrosionsschutzschicht 30 schematisch auf einer Kühlstruktur bzw. einem Kühlkörper 20 dargestellt. Vorzugsweise weist eine solche Korrosionsschutzschicht eine Dicke D auf, die einen Wert annimmt, der kleiner ist als 3 µm, bevorzugt kleiner als 1000 nm und besonders bevorzugt kleiner als 500 nm. Insbesondere ist es vorgesehen, dass die Korrosionsschutzschicht 30 eine Dicke D aufweist zwischen 100 und 200 nm. Dabei lassen sich insbesondere Dicken von weniger als 3 µm durch ein Sol-Gel-Verfahrens herstellen, während ein Beschichten mit einer Korrosionsschutzschicht von weniger als 500 nm bevorzugt durch ein gasphysikalisches Abscheiden erfolgt. Insbesondere die sehr dünnen Korrosionsschutzschichten 30 mit Dicken D von weniger als 500 nm erweisen sich im Falle von Mikrokanalsystemen bzw. Mikrokanälen als besonders vorteilhaft, da dadurch verhindert wird, dass der ohnehin geringe Durchmesser von Mikrokanälen nicht weiter reduziert wird. Außerdem wird verhindert, dass durch die aufgetragene Korrosionsschutzschicht 30 eine thermische Barriere erzeugt wird, die von der Wärme beim Übergang vom Kühlkörper 20 auf die Kühlflüssigkeit andernfalls überwunden werden müsste. Besonders bevorzugt ist es dabei vorgesehen, dass eine SiO₂-Schicht vorgesehen ist, die die Kühlstruktur 20 oder zumindest teilweise seine Außenseite bzw. mit dem Kühlmedium in Kontakt stehende Oberfläche umfasst.

Vorzugsweise ist es vorgesehen, dass die Innenseiten und/oder Finnenelemente bzw. die stegartigen Elemente 7 der Kühlstruktur 20 mit der Korrosionsschutzschicht 30 sowie Bereiche, für den Anschluss bzw. die Abdichtung des Kühlers zur Umgebung dienen versehen sind. Besonders bevorzugt ist es vorgesehen, dass Innenseiten von Mikrokanalbereichen bzw. Mikrokanälen mit der Korrosionsschutzschicht 30 versehen sind.

### Bezugszeichenliste:

- 1: Trägerelement
- 4: elektrisches Bauteil
- 5: Bauteilseite
- 6: Kühlseite
- 7: stegartiges Element
- 11: erste Metallschicht
- 12: zweite Metallschicht
- 13: dritte Metallschicht
- 14: untere Deckschicht
- 15: obere Deckschicht
- 21: erster Teil
- 22: zweiter Teil
- 24: weitere Ausnehmung
- 25: Finnenstruktur
- 30: Anschlussfläche
- 33: Querbereich
- 34: Schenkelbereich
- 40: Verteilstruktur
- 41: einleitender Teil
- 42: ableitender Teil
- 50: Zuführstruktur
- 70: Metall-Keramik-Substrat
- 71: Keramikelement
- 72: Bauteilmetallisierung
- 75: Zwischenschicht
- 73: Sekundärschicht
- A1: Abstand
- A2: weiterer Abstand
- S: Stapelrichtung
- T1: erster Teilabschnitt
- T2: zweiter Teilabschnitt
- Q: Querrichtung
- Q1: erste Querschnittsöffnung
- Q2: zweite Querschnittsöffnung
- M: Mittelachse
- D: Dicke
- V: Versatzabstand
- RR: Reihenrichtung
- HS1: erste Hauptströmungsrichtung
- HS2: zweite Hauptströmungsrichtung
- HSE: Haupterstreckungsebene

## Patentansprüche

1. Trägerelement (1) für elektrische Bauteile (4), wobei das Trägerelement (1) zum Abführen von Wärme, die vom elektrischen Bauteil während dessen Betrieb ausgeht, einen metallischen Kühlkörper (20) umfasst, wobei der Kühlkörper (20) eine Metallkörnung mit einer durchschnittlichen Korngröße aufweist, wobei die durchschnittliche Korngröße in einem Bereich zwischen 10 µm und 800 µm, bevorzugt zwischen 100 µm und 700 µm und besonders bevorzugt zwischen 300 und 600 µm liegt, **dadurch gekennzeichnet, dass** der Kühlkörper (20) zumindest abschnittsweise eine oxidhaltige Korrosionsschutzschicht (30) umfasst.

2. Trägerelement (1) gemäß Anspruch 1, wobei der Kühlkörper (20) mindestens aus einer ersten Metallschicht (21) und einer zweiten Metallschicht (22) zusammengesetzt ist.

3. Trägerelement (1) gemäß einem der vorhergehenden Ansprüche, wobei das Trägerelement (1) ein Metall-Keramik-Substrat (70) umfasst.

4. Trägerelement (1) gemäß Anspruch 1, wobei die Korrosionsschutzschicht SiO₂, TiO₂, Al₂O₃, ZrO, CaO, K2O und/oder ZnO umfasst.

5. Trägerelement (1) gemäß einem der vorhergehenden Ansprüche, wobei die Korrosionsschutzschicht (30) eine Dicke (D) von weniger als 3 µm, bevorzugt weniger als 1000 nm und besonders bevorzugt weniger als 500 nm aufweist.

6. Trägerelement (1) gemäß einem der vorhergehenden Ansprüche, wobei der Kühlkörper (20) strukturiert ist und/oder mindestens einen Mikrokanal umfasst.

7. Trägerelement (1) gemäß einem der vorhergehenden Ansprüche, wobei ein Abstand (A1) zwischen gegenüberliegenden Seitenwänden in der mindestens einen ersten Metallschicht (21)
- zumindest bereichsweise kleiner als 0,4 mm, bevorzugt kleiner als 0,3 mm und besonders bevorzugt kleiner als 0,2 mm ist oder
- ein Wert annimmt, der zwischen 0,5 mm und 2,5 mm, bevorzugt zwischen 0,7 mm und 1,5 mm und besonders bevorzugt zwischen 0,8 mm und 1,2 mm liegt.

8. Trägerelement (1) gemäß einem der vorhergehenden Ansprüche, wobei der Kühlkörper (20) aus Kupfer und/oder Aluminium gefertigt ist.

9. Verfahren zur Herstellung eines Trägerelements (1) gemäß einem der vorhergehenden Ansprüche, wobei der Kühlkörper zu dessen Bildung und/oder zum Anbinden an eine Metallschicht und/oder an ein Keramikelement einer Temperatur oberhalb von 600 °C ausgesetzt wird.

10. Verfahren gemäß Anspruch 9, wobei der Kühlkörper zur Ausbildung der Korrosionsschutzschicht (30) einer Temperatur zwischen 100 °C und 500 °C, bevorzugt zwischen 200° und 400° und besonders bevorzugt zwischen 250° und 350°C ausgesetzt wird.

11. Verfahren gemäß Anspruch 9 oder 10, wobei die Korrosionsschutzschicht (30) mittels gasphysikalischen Abscheiden auf dem Kühlkörper (20) aufgetragen wird.

## Claims

1. Carrier element (1) for electrical components (4), wherein the carrier element (1) comprises a metallic heat sink (20) for dissipating heat emitted by the electrical component during its operation, wherein the heat sink (20) has a metal grain with an average grain size, wherein the average grain size is in a range between 10 µm and 800 µm, more preferably between 100 µm and 700 µm, and most preferably between 300 and 600 µm, **characterized in that** the heat sink (20) comprises, at least partially, an oxide-containing anti-corrosion layer (30).

2. Carrier element (1) according to claim 1, wherein the heat sink (20) is composed of at least a first metal layer (21) and a second metal layer (22).

3. Support element (1) according to one of the preceding claims, wherein the support element (1) comprises a metal-ceramic substrate (70).

4. Support element (1) according to claim 1, wherein the anti-corrosion layer comprises SiO₂, TiO₂, Al₂O₃, ZrO, CaO, K₂O, and/or ZnO.

5. Support element (1) according to one of the preceding claims, wherein the anti-corrosion layer (30) has a thickness (D) of less than 3 µm, more preferably less than 1000 nm, and most preferably less than 500 nm.

6. Support element (1) according to one of the preceding claims, wherein the heat sink (20) is structured and/or comprises at least one microchannel.

7. Supporting element (1) according to one of the preceding claims, wherein a distance (A1) between opposite side walls in the at least one first metal layer (21).
- is at least in some areas less than 0.4 mm, more preferably less than 0.3 mm, and most preferably less than 0.2 mm, or
- has a value between 0.5 mm and 2.5 mm, more preferably between 0.7 mm and 1.5 mm, and most preferably between 0.8 mm and 1.2 mm.

8. Support element (1) according to one of the preceding claims, wherein the heat sink (20) is produced from copper and/or aluminum.

9. The method for manufacturing a carrier element (1) according to one of the preceding claims, wherein the heat sink (20) is exposed to a temperature above 600 °C for its formation and/or for bonding to a metal layer and/or to a ceramic element.

10. The method according to claim 9, wherein the heat sink (20) is exposed to a temperature between 100°C and 500°C, more preferably between 200° and 400°, and most preferably between 250° and 350°C, in order to form the anti-corrosion layer (30).

11. The method according to claim 9 or 10, wherein the anti-corrosion layer (30) is deposited on the heat sink (20) by means of physical vapor deposition.

## Revendications

1. Élément porteur (1) pour des composants électriques (4), l'élément porteur (1) comprenant un dissipateur thermique métallique (20) pour dissiper la chaleur dégagée par le composant électrique pendant son fonctionnement, le dissipateur thermique (20) présentant une granulométrie métallique avec une taille de grain moyenne, la taille de grain moyenne se situant dans une plage comprise entre 10 µm et 800 µm, de préférence entre 100 µm et 700 µm et de manière particulièrement préférée entre 300 et 600 µm,
**caractérisé en ce que** le dissipateur thermique (20) comprend au moins localement une couche anticorrosion (30) contenant de l'oxyde.

2. Élément porteur (1) selon la revendication 1,
dans lequel le dissipateur thermique (20) est composé au moins d'une première couche métallique (21) et d'une deuxième couche métallique (22).

3. Élément porteur (1) selon l'une des revendications précédentes,
dans lequel l'élément porteur (1) comprend un substrat métal-céramique (70).

4. Élément porteur (1) selon la revendication 1,
dans lequel la couche anticorrosion contient du SiO₂, TiO₂, Al₂O₃, ZrO, CaO, K₂O et/ou ZnO.

5. Élément porteur (1) selon l'une des revendications précédentes,
dans lequel la couche anticorrosion (30) présente une épaisseur (D) inférieure à 3 µm, de préférence inférieure à 1000 nm et de manière particulièrement préférée inférieure à 500 nm.

6. Élément porteur (1) selon l'une des revendications précédentes,
dans lequel le dissipateur thermique (20) est structuré et/ou présente au moins un micro-canal.

7. Élément porteur (1) selon l'une des revendications précédentes,
dans lequel la distance (A1) entre des parois latérales opposées dans ladite au moins une première couche métallique (21)
- est au moins localement inférieure à 0,4 mm, de préférence inférieure à 0,3 mm et de manière particulièrement préférée inférieure à 0,2 mm, ou
- prend une valeur comprise entre 0,5 mm et 2,5 mm, de préférence entre 0,7 mm et 1,5 mm et de manière particulièrement préférée entre 0,8 mm et 1,2 mm.

8. Élément porteur (1 ) selon l'une des revendications précédentes,
dans lequel le dissipateur thermique (20) est fabriqué en cuivre et/ou en aluminium.

9. Procédé de fabrication d'un élément porteur (1) selon l'une des revendications précédentes,
dans lequel le dissipateur thermique est soumis à une température supérieure à 600 °C pour sa formation et/ou pour sa liaison à une couche métallique et/ou à un élément céramique.

10. Procédé selon la revendication 9,
dans lequel le dissipateur thermique est soumis à une température comprise entre 100 °C et 500 °C, de préférence entre 200 °C et 400 °C et de manière particulièrement préférée entre 250 °C et 350 °C, pour la formation de la couche anticorrosion (30).

11. Procédé selon la revendication 9 ou 10,
dans lequel la couche anticorrosion (30) est appliquée sur le dissipateur thermique (20) par dépôt physique en phase vapeur.
